(19) Europäisches Patentamt
European Patent Office
Office européen des brevets

(11) **EP 1 162 748 B1**

(12) **FASCICULE DE BREVET EUROPEEN**

(45) Date de publication et mention
de la délivrance du brevet:
**17.11.2004 Bulletin 2004/47**

(51) Int Cl.⁷: **H03M 1/10**
// H03M1/42

(21) Numéro de dépôt: **01401421.1**

(22) Date de dépôt: **31.05.2001**

(54) **Dispositif et procédé de contrôle de condensateurs intégrés**

Vorrichtung und Verfahren zum Überprüfen von integrierten Kondensatoren

Apparatus and method for checking integrated capacitors

(84) Etats contractants désignés:
**DE FR**

(30) Priorité: **06.06.2000 FR 0007227**

(43) Date de publication de la demande:
**12.12.2001 Bulletin 2001/50**

(73) Titulaire: **STMicroelectronics S.A.**
**92120 Montrouge (FR)**

(72) Inventeurs:
• **Bianchi, Raul Andés**
**38000 Grenoble (FR)**
• **Froment, Benoît**
**38920 Crolles (FR)**

(74) Mandataire: **Casalonga, Axel**
**BUREAU D.A. CASALONGA - JOSSE**
**Paul-Heyse-Strasse 33**
**80336 München (DE)**

(56) Documents cités:
• **MILLER R W ET AL: "AN ACOUSTIC CHARGE TRANSPORT DIGITALLY PROGRAMMABLE TRANSVERSAL FILTER" IEEE JOURNAL OF SOLID-STATE CIRCUITS,US,IEEE INC. NEW YORK, vol. 24, no. 6, décembre 1989 (1989-12), pages 1675-1682, XP000100501 ISSN: 0018-9200**
• **SINGH S P ET AL: "DESIGN METHODOLOGIES FOR C-2C LADDER-BASED D/A CONVERTORS FOR PCM CODECS" IEE PROCEEDINGS G. ELECTRONIC CIRCUITS & SYSTEMS,GB,INSTITUTION OF ELECTRICAL ENGINEERS. STEVENAGE, vol. 135, no. 4, PART G, août 1988 (1988-08), pages 133-140, XP000006255 ISSN: 0622-0039**
• **FROMENT B ET AL: "Ultra low capacitance measurements in multilevel metallisation CMOS by using a built-in electron-meter" INTERNATIONAL ELECTRON DEVICES MEETING 1999. TECHNICAL DIGEST (CAT. NO.99CH36318), WASHINGTON, DC, USA, 5-8 DEC. 1999, pages 897-900, XP002164650 1999, Piscataway, NJ, USA, IEEE, USA ISBN: 0-7803-5410-9**

## Description

L'invention concerne les circuits intégrés, et plus particulièrement le contrôle de condensateurs intégrés, tel que le contrôle de l'appariement ("matching" en langue anglaise) et de la linéarité de ces condensateurs intégrés.

L'invention s'applique avantageusement mais non exclusivement au contrôle de la qualité de condensateurs de circuits intégrés réalisés en production. Elle trouve également une application dans le domaine des convertisseurs analogiques-numériques fonctionnant sur le principe des capacités commutées.

Un circuit intégré, comportant par exemple un convertisseur analogique numérique à capacités commutées, peut comporter en théorie un certain nombre de condensateurs identiques en terme de valeurs capacitives. Néanmoins, une fois que le circuit intégré a été réalisé sur silicium, ces condensateurs, théoriquement identiques, présentent en pratique des caractéristiques réelles légèrement différentes. Ces caractéristiques réelles se traduisent notamment par des défauts d'appariement, c'est-à-dire qu'il existe des différences entre leurs valeurs capacitives réelles respectives. Ces défauts d'appariement sont dus par exemple à des surfaces d'armatures légèrement différentes d'un condensateur à l'autre ou bien à des différences de permittivité des diélectriques d'un condensateur à l'autre. Les causes de ces différences sont généralement liées aux aléas inévitables du procédé de fabrication (qualité d'oxyde déposé non-uniforme, utilisation de plasma, emplacement des condensateurs sur la plaquette, ...).

Ces mêmes aléas peuvent conduire à des condensateurs présentant des défauts de linéarité, généralement dus à la qualité du diélectrique. On rappelle ici qu'une non-linéarité d'un condensateur se traduit par une valeur capacitive dépendante de la tension appliquée à ses bornes, alors qu'en théorie un condensateur est "linéaire", c'est-à-dire que sa valeur capacitive est indépendante de la tension appliquée à ses bornes. Un exemple d'un circuit intégré est montré dans XP000006255, "Design methodologies for C-2C ladder based D/A converters for PCM codecs", S.P. Singh et al.

Actuellement, il existe des lois statistiques permettant de déterminer notamment les défauts d'appariement pour des paires de condensateurs adjacents.

Cependant, on ne connaît pas actuellement une façon simple de contrôler les caractéristiques de condensateurs réalisés, et notamment de déterminer simultanément les défauts d'appariement et de linéarité de condensateurs intégrés en théorie identiques.

L'invention vise à remédier à cette lacune.

L'invention a pour but de proposer un contrôle simple de contrôle de condensateurs réalisés.

Un autre but de l'invention est de proposer un système permettant de déterminer à la fois le défaut d'appariement et la non-linéarité de condensateurs intégrés théoriquement identiques, à l'aide d'un unique paramètre décisionnel qui s'apparente à une résolution en nombre de bits.

L'invention a également pour but d'utiliser ce système pour contrôler très rapidement et très efficacement le défaut d'appariement et la non-linéarité de condensateurs théoriquement identiques appartenant à des circuits intégrés réalisés en production sur une plaquette semi-conductrice.

L'invention a encore pour but de déterminer très simplement la résolution maximale réelle de convertisseurs analogiques-numériques réalisés sur circuits intégrés.

L'invention a également pour but de proposer un générateur de tensions de référence pour convertisseurs analogiques-numériques qui soit particulièrement robuste et précis.

L'invention propose donc un dispositif de contrôle de condensateurs intégrés théoriquement identiques, ce dispositif comprenant une structure capacitive possédant un noeud d'entrée et n noeuds de sortie, n étant un entier supérieur ou égal à 2. La structure capacitive possède également r condensateurs intégrés connectés en série entre deux noeuds voisins, r étant un entier supérieur ou égal à 1. Cette structure capacitive possède encore 1 condensateur intégré connecté entre le noeud d'entrée et la masse et 1 condensateur intégré connecté entre le $n^{\text{ème}}$ noeud de sortie et la masse. Cette structure capacitive possède en outre r branches capacitives connectées en parallèle entre la masse et chaque noeud de la structure capacitive incluant le premier noeud de sortie et le $n\text{-}1^{\text{ème}}$ noeud de sortie. Chaque branche comporte r+1 condensateurs intégrés connectés en série. Tous les condensateurs de la structure capacitive sont théoriquement identiques.

Le dispositif de contrôle comporte, outre cette structure capacitive :

- des moyens de charge aptes à charger chaque noeud de la structure capacitive,
- des moyens de mesure aptes à mesurer la charge dans chacun des noeuds de la structure, et
- des moyens de comparaison aptes à comparer chaque valeur nodale de charge mesurée avec une valeur nodale de charge théorique, compte tenu d'une tolérance nodale prédéterminée.

Bien que r puisse en théorie prendre une valeur entière supérieure ou égale à 1, il est particulièrement intéressant de choisir r=1, ce qui permet d'obtenir un rapport 2 entre les tensions présentes à deux noeuds adjacents de la structure capacitive. Ceci est particulièrement bien adapté en particulier à la conversion analogique-numérique.

Selon un mode de réalisation, les moyens de charge comportent une source de tension de référence et un interrupteur commandable connecté entre la source de tension et le noeud d'entrée.

Selon un mode de réalisation, les moyens de mesure comportent pour chaque noeud de la structure capacitive, un interrupteur commandable de mesure connecté audit noeud, et un ampèremètre apte à être connecté entre l'interrupteur de mesure et la masse.

L'utilisation d'un ampèremètre pour mesurer une charge dans chacun des noeuds de la structure capacitive, est particulièrement avantageuse par rapport à une solution consistant à mesurer des tensions aux bornes de condensateurs car un voltmètre présente des capacités parasites, ce qui peut fausser la mesure.

Le dispositif comprend également avantageusement, pour chaque noeud de la structure capacitive, un interrupteur commandable de décharge connecté entre ledit noeud et la masse. Ceci permet de décharger tous les condensateurs avant la mesure.

Le dispositif selon l'invention est avantageusement utilisé pour le contrôle de condensateurs intégrés appartenant à un circuit intégré situé sur une pastille d'une plaquette semi-conductrice et délimitée par des chemins de découpe ménagés dans ladite plaquette. La structure capacitive est alors avantageusement insérée dans l'un des chemins de découpe délimitant ladite pastille et la surface d'armature des condensateurs de la structure capacitive est alors choisie au plus égale à la surface d'armature minimale des condensateurs du circuit intégré.

En d'autres termes, si par exemple le circuit intégré comporte des condensateurs de même surface d'armature, on choisira alors une structure capacitive constituée de condensateurs de surface d'armature identique. Cependant, si le circuit intégré comporte des condensateurs ayant des surfaces d'armatures différentes, par exemple un groupe de condensateurs ayant une première surface d'armature prédéterminée, et un autre groupe de condensateurs ayant une deuxième surface d'armature égale à la moitié de la première surface d'armature, on choisira alors une structure capacitive dont les condensateurs présentent une surface d'armature égale à la deuxième surface d'armature.

En effet, plus la surface d'armature des condensateurs est grande, meilleur est l'appariement entre ces condensateurs. Aussi, si le dispositif de contrôle de l'invention conduit à un appariement jugé acceptable pour des condensateurs ayant la surface minimale, il en sera à fortiori de même pour les condensateurs ayant une surface plus grande.

La structure capacitive du dispositif selon l'invention peut également être utilisée en tant que générateur de tensions ou de charges de référence pour un convertisseur analogique-numérique à capacités commutées. Dans ce cas, une source de tension est connectée au noeud d'entrée. Les différentes tensions ou charges de référence sont alors respectivement disponibles au niveau des différents noeuds (qui sont des noeuds de sortie) de la structure capacitive.

L'utilisation d'une telle structure capacitive pour des convertisseurs analogiques-numériques à capacités commutées est particulièrement avantageuse en raison de son caractère moins sensible aux défauts d'appariement des condensateurs ainsi qu'à leurs défauts de linéarité.

L'invention a également pour objet un procédé de contrôle de condensateurs intégrés théoriquement identiques, procédé dans lequel :

- on réalise une structure capacitive possédant un noeud d'entrée et n noeuds de sortie, n est un entier supérieur ou égal à 2, r condensateurs intégrés connectés en série entre deux noeuds voisins, r étant un entier supérieur ou égal à 1, un condensateur intégré connecté entre le noeud d'entrée et la masse, un condensateur intégré connecté entre le n$^{ème}$ noeud de sortie et la masse, r branches capacitives connectées en parallèle entre la masse et chaque noeud de la stucture capacitive incluant le premier noeud de sortie et le n-1$^{ème}$ noeud de sortie, chaque branche comportant r+1 condensateurs intégrés connectés en série, tous les condensateurs de la structure capacitive étant théoriquement identiques,
- on charge chaque noeud de la structure capacitive par le noeud d'entrée,
- on mesure la charge en chacun des noeuds de la structure, et
- on compare chaque valeur nodale de charge mesurée avec une valeur nodale de charge théorique compte tenu d'une tolérance nodale prédéterminée.

Selon un mode de mise en oeuvre de l'invention, la charge d'un noeud et la mesure de la charge en ce noeud comportent la succession des étapes suivantes, effectuées à une fréquence prédéterminée pendant une durée prédéterminée :

- décharge de tous les noeuds,
- charge de tous les noeuds,
- connexion d'un ampèremètre entre le noeud à mesurer et la masse,
- déconnexion de l'ampèremètre.

En d'autres termes, on mesure plusieurs fois par seconde la charge au noeud considéré, ce qui permet d'obtenir une moyenne des mesures conduisant à une lecture plus précise et à une élimination du bruit capacitif de nature aléatoire.

La fréquence doit être suffisamment élevée pour permettre à l'ampèremètre d'effectuer une moyenne et de délivrer un courant suffisamment grand, donc pouvant être mesuré avec une bonne précision. Par contre, cette fréquence ne doit pas être trop élevée pour éviter l'injection de charges dans les interrupteurs, provoquant des phénomènes parasites.

L'homme du métier saura ajuster la valeur de cette fréquence en fonction des caractéristiques de la structure capacitive et de l'application considérée.

A titre indicatif, pour une structure capacitive dont les condensateurs présentent une valeur capacitive de 1 pF, on pourra choisir une fréquence comprise entre 100 KHz et 10 MHz, par exemple de l'ordre de 1 MHz et l'on effectuera la mesure sur une durée de l'ordre de la seconde, par exemple de l'ordre de 3 secondes.

D'autres avantages et caractéristiques de l'invention apparaîtront à l'examen de la description détaillée de modes de mise en oeuvre et de réalisation, nullement limitatifs, et des dessins annexés sur lesquels :

- la figure 1 illustre de façon très schématique un mode de réalisation d'un dispositif selon l'invention;
- la figure 2 illustre également très schématiquement un organigramme de fonctionnement du dispositif de la figure 1, permettant une mise en oeuvre du procédé selon l'invention;
- la figure 3 illustre toujours très schématiquement l'application du dispositif et du procédé selon l'invention au contrôle du défaut d'appariement et de non linéarité de condensateurs de circuits intégrés réalisés sur une plaquette semi-conductrice; et
- la figure 4 illustre toujours très schématiquement l'utilisation de la structure capacitive selon l'invention dans un convertisseur analogique-numérique à capacités commutées.

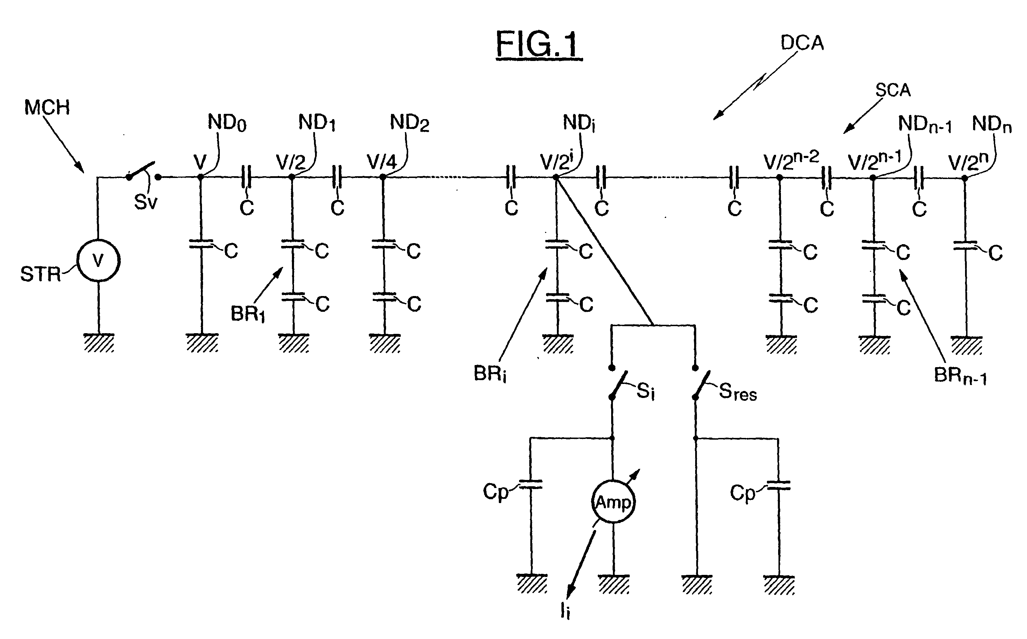

Sur la figure 1, la référence DCA désigne un dispositif de contrôle selon l'invention. Ce dispositif de contrôle comporte une structure capacitive SCA possédant un noeud d'entrée $ND_0$ et n noeuds de sortie $ND_1$-$ND_n$. n est un entier supérieur ou égal à 2.

La structure capacitive comporte par ailleurs un condensateur intégré C connecté en série entre deux noeuds voisins $ND_i$ et $ND_{i+1}$.

Il est également prévu un condensateur intégré C connecté en série entre le $n^{ème}$ noeud de sortie, c'est-à-dire ici le noeud $ND_n$, et la masse, ainsi qu'un condensateur intégré C connecté en série entre le noeud d'entrée, c'est-à-dire ici le noeud $ND_0$, et la masse.

La structure capacitive comporte par ailleurs une branche capacitive $BR_i$ connectée entre la masse et chaque noeud $ND_i$ de la structure capacitive, incluant le premier noeud de sortie $ND_1$ et le n-$1^{ème}$ noeud de sortie $ND_{n-1}$. En d'autres termes, la structure capacitive CA comporte n-1 branches capacitives $BR_1$-$BR_{n-1}$ respectivement connectées aux noeuds $ND_1$-$ND_{n-1}$.

Chaque branche capacitive $BR_i$ comporte deux condensateurs intégrés C connectés en série.

Tous les condensateurs C de la structure capacitive sont théoriquement identiques. En pratique, ils sont réalisés de façon intégrée au sein d'un substrat semi-conducteur.

On verra plus en détail ci-après que, lorsque le dispositif de contrôle DCA est utilisé pour contrôler des condensateurs de circuits intégrés réalisés sur une plaquette semi-conductrice, les condensateurs de la structure capacitive et les condensateurs des circuits intégrés sont réalisés simultanément selon le même procédé de fabrication.

Le dispositif de contrôle DCA comporte, outre la structure capacitive SCA, des moyens de charge MCH aptes à charger chaque noeud de la structure capacitive. Ces moyens MCH comportent ici une source de tension de référence STR délivrant une tension de référence V au noeud d'entrée $ND_0$ par l'intermédiaire d'un interrupteur commandable Sv.

Le dispositif DCA comporte en outre des moyens de mesure aptes à mesurer la charge en chacun des noeuds de la structure capacitive. Ces moyens de mesure comportent ici, pour chaque noeud de la structure capacitive, un interrupteur de mesure commandable $S_i$ connecté au noeud $ND_i$, ainsi qu'un ampèremètre Amp connecté entre l'interrupteur de mesure $S_i$ et la masse.

Il est également prévu, pour chaque noeud $ND_i$ de la structure capacitive, un interrupteur commandable de décharge $S_{res}$, connecté entre le noeud $ND_i$ et la masse.

Sur la figure 1, la référence $C_p$ désigne des condensateurs représentatifs des capacités parasites du système.

La structure capacitive SCA selon l'invention présente des propriétés remarquables, à savoir une division de tension de noeud à noeud et une valeur capacitive constante en chaque noeud.

Plus précisément, avec le mode de réalisation illustré sur la figure 1 (r=1), la tension à chaque noeud de la structure SCA se divise par deux par rapport à la tension au noeud amont. Si l'on se rapporte à la tension V de la source de tension de référence STR, la tension $V_i$ en chaque noeud $ND_i$ de la structure SCA est égale à $V/2^i$.

De même, dans le mode de réalisation illustré sur la figure 1, la valeur capacitive en chaque noeud $ND_i$ est

constante et est égale à 3C/2.

Bien entendu, les valeurs de la capacité en chaque noeud ainsi que la valeur de la tension en chaque noeud, indiquées ci-dessus, sont des valeurs théoriques pour le cas où les condensateurs C seraient tous théoriquement identiques.

En pratique, il en va différemment compte tenu notamment du défaut d'appariement des condensateurs ainsi que de leur non-linéarité.

Une solution consisterait à mesurer précisément la tension réelle $V_i$ en chaque noeud de la structure capacitive réalisée et de la comparer à la valeur théorique. Cependant, ceci nécessiterait l'utilisation d'un voltmètre qui, en raison de sa capacité parasite, pourrait fausser la mesure. Aussi, l'invention prévoit-elle avantageusement de mesurer la charge $Q_i$ en chaque noeud $ND_i$ de la structure capacitive de façon à obtenir un valeur représentative de la tension $V_i$ sans capacité parasite dans la chaîne de mesure.

Par ailleurs, la charge en chaque noeud se divise de la même manière que la tension en chaque noeud.

Une façon particulièrement simple et efficace de mesurer cette charge consiste à mesurer le courant $I_i$ en chaque noeud à l'aide de l'ampèremètre Amp.

En effet, toutes les capacités parasites sont alors court-circuitées par l'ampèremètre. En outre, au lieu d'effectuer une seule mesure qui serait théoriquement possible, on effectue une mesure plusieurs fois par seconde, ce qui permet de moyenner la lecture de façon à obtenir une lecture plus précise et d'obtenir un courant $I_i$ suffisamment grand. Par ailleurs, cette façon de procéder permet d'éliminer le bruit capacitif aléatoire.

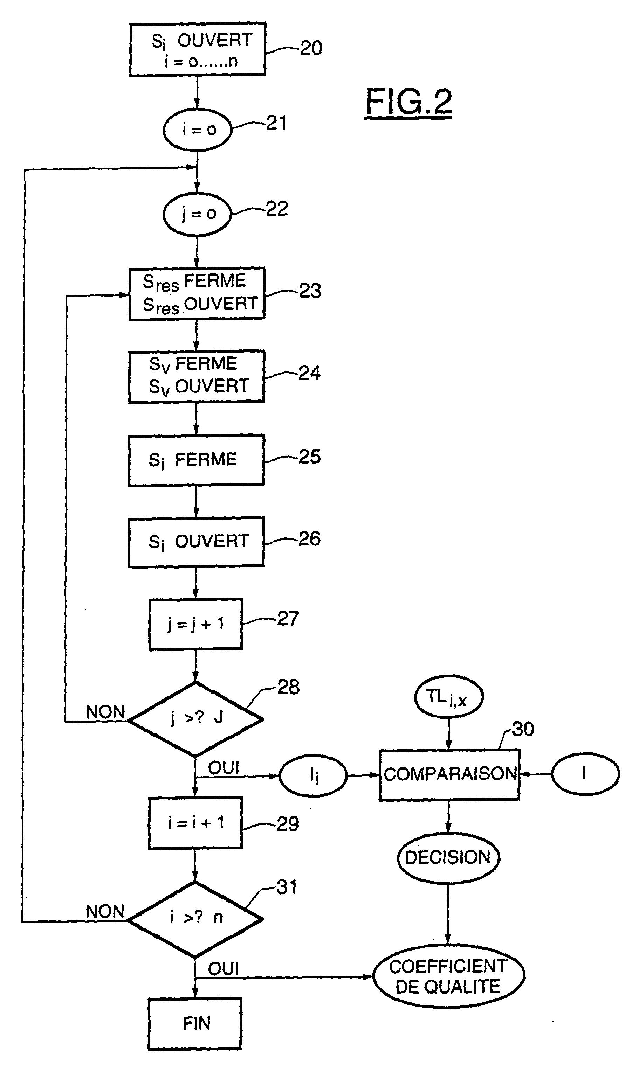

On se réfère maintenant plus particulièrement à la figure 2, pour décrire plus en détail un tel mode de mise en oeuvre.

La charge $Q_i$, ou encore le courant $I_i$, va successivement être calculé en chacun des noeuds $ND_i$ avec i variant de 0 à n.

Au début du processus, tous les interrupteurs $S_i$ sont ouverts (étape 20). On initialise le compteur i et un compteur j (étapes 21 et 22).

Dans l'étape 23, on décharge tous les noeuds, et en conséquence le noeud considéré, en fermant et en ouvrant successivement l'interrupteur $S_{res}$.

Dans l'étape 24, on ferme tout d'abord l'interrupteur $S_v$ pendant une durée prédéterminée, de façon à charger les noeuds de la structure SCA.

A titre indicatif, pour un condensateur C ayant une valeur capacitive de 1 pF, on peut laisser l'interrupteur $S_v$ fermé pendant 100 ns.

On ouvre ensuite l'interrupteur $S_v$ de façon à permettre la lecture ultérieure.

Pour effectuer cette lecture, on ferme dans l'étape 25 l'interrupteur $S_i$ puis, après une durée prédéterminée de mesure, on ouvre à nouveau cet interrupteur $S_i$ dans l'étape 26.

Après avoir incrémenté le compteur j d'une unité (étape 27), on recommence le cycle des étapes 23 à 27 jusqu'à ce que le compteur j atteigne une valeur finale prédéterminée J correspondant à une durée prédéterminée de mesure.

A titre indicatif, la durée d'un cycle de décharge de charge et de mesure (étapes 23 à 26) est de l'ordre de 1 ms correspondant à une fréquence $f$ de 1 MHz. Le nombre J est choisi de façon à avoir une intégration de la mesure sur une durée de l'ordre de la seconde, par exemple de l'ordre de 3 secondes.

Comme indiqué ci-avant, la fréquence $f$ doit être suffisamment élevée pour permettre une lecture précise du courant avec une valeur de courant suffisamment importante, par exemple de l'ordre de 1 mA, mais pas trop élevée pour éviter l'apparition de phénomènes parasites dus notamment à l'injection de charges dans les interrupteurs. On choisira donc à titre indicatif pour un condensateur C ayant une valeur capacitive de 1 pF, une fréquence comprise entre 100 KHz et 10 MHz.

Une fois la mesure $I_i$ effectuée, on incrémente le compteur i d'une unité (étape 29), et on réexécute l'algorithme de décharge, de charge, et de mesure jusqu'à ce que tous les noeuds de la structure capacitive aient été considérés (étape 31).

Si l'on revient maintenant à la mesure du courant $I_i$, la valeur de ce courant est définie par la formule (1) ci-dessous :

$$I_i = f \cdot Q_i = f \cdot (V/2^j) \cdot (3C/2) \qquad (1)$$

De même, la valeur théorique du courant $I_0$, c'est-à-dire le courant au noeud d'entrée, est défini par la formule (2) ci-dessous :

$$I_0 = f \cdot Q_0 = f \cdot V \cdot 3C/2 \tag{2}$$

Bien entendu, les valeurs exprimées dans les formules (1) et (2) sont des valeurs théoriques.

En pratique, compte tenu notamment des défauts d'appariement et de linéarité, le rapport des courants réels $I_i$ et $I_0$ est défini par la formule (3) et peut s'analyser comme la somme d'une valeur théorique $TH_i$ $\pm$ une tolérance $TL_{i,x}$.

$$I_i/I_0 = Q_i/Q_0 = \underbrace{(1/2^i)}_{TH_i} \pm \underbrace{(1/2^{i+x})}_{TL_{i,x}} \tag{3}$$

En d'autres termes, la comparaison, effectuée dans l'étape (30) de chaque valeur nodale de charge mesurée avec une valeur nodale de charge théorique, compte tenu d'une tolérance nodale prédéterminée, se traduit ici par la comparaison d'un rapport de courant par rapport à une valeur théorique $TH_i$, compte tenu d'une tolérance prédéterminée $TL_{i,x}$.

Il est ainsi possible d'affecter un coefficient de qualité CQx, vis-à-vis notamment du défaut de linéarité et d'appariement, à la structure capacitive SCA.

Ce coefficient de qualité CQx est en fait l'indice i du dernier noeud $ND_i$ dont le courant $I_i$ satisfait à la formule (3), c'est-à-dire dont le courant $I_i$ se situe dans la fourchette de tolérance fixée.

Ainsi, une structure capacitive ayant le coefficient de qualité 4 présentera un moins grand défaut de linéarité et un meilleur appariement qu'une structure capacitive ayant obtenue le coefficient de qualité 2.

L'entier x dans la formule (3) peut prendre des valeurs supérieure ou égale à 1. Pour toute valeur de x, le critère de tolérance défini par la formule (3) est plus sensible aux défauts de linéarité qu'aux défauts d'appariement. Par contre, une sensibilité égale pour les défauts de linéarité et pour les défauts d'appariement est obtenue avec le critère accumulatif défini par la formule (4) ci-dessous :

$$\prod_{k=1}^{i} \left( \frac{\left| \dfrac{2\,I_k}{I_{k-1}} - 1 \right| + 1}{2} \right) = \underbrace{(1/2^i)}_{TH_i} \pm \underbrace{(1/2^{i+x})}_{TL_{i,x}} \tag{4}$$

dans laquelle i désigne l'indice du noeud considéré.

L'entier x dans la formule (4) (avec $x \geq 1$) permet d'augmenter la sensibilité d'une structure capacitive SCA pour une valeur de "n" fixe et donnée. Typiquement, si pour une structure SCA pour laquelle n est égal à 20, le coefficient de qualité CQ1, obtenu pour x égal à 1, avait sa valeur limite égale à 20, le fait d'utiliser une valeur de x égale à 2 par exemple, permettrait d'élargir virtuellement la limite de caractérisation de la structure SCA, et d'obtenir un critère de qualité CQ2 inférieur à 20 correspondant à une contrainte plus importante.

D'autres critères, autres que ceux définis par les formules (3) et (4), peuvent être également utilisés.

Matériellement, on peut prévoir un microprocesseur mettant en oeuvre par logiciel l'organigramme de la figure 2, de façon à commander les différents interrupteurs et à effectuer les comparaisons prévues à l'étape 30. De même, l'ampèremètre peut être physiquement relié aux différents plots de contact de la structure capacitive SCA au moyen de pointes d'un testeur classique.

La structure capacitive SCA peut être utilisée pour différentes applications. Elle peut permettre de tester par exemple des procédés différents de fabrication de condensateurs, de façon à utiliser le procédé qui conduira à minimiser les défauts de linéarité et d'appariement dans les condensateurs.

La structure SCA permet également de caractériser très simplement la résolution maximale réelle d'un convertisseur analogique-numérique à capacités commutées. En effet, le coefficient de qualité que l'on a évoqué plus haut, c'est-à-dire le nombre correspondant à l'indice du dernier noeud de la structure ayant satisfait au critère défini par la formule (3) notamment ou par la formule (4) par exemple, correspond en fait à un nombre de bits représentatif de la résolution maximale du convertisseur analogique-numérique à capacités commutées.

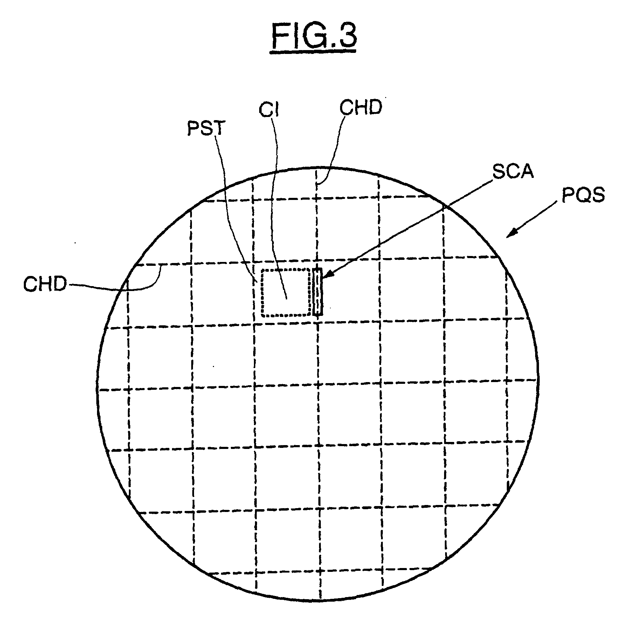

L'invention permet également de contrôler le défaut d'appariement et de linéarité de condensateurs de circuits intégrés ou bien la résolution maximale réelle de convertisseurs analogiques-numériques à capacités commutées, en réalisant cette structure capacitive dans des chemins de découpe d'une plaquette semi-conductrice PQS telle que celle illustrée sur la figure 3.

En effet, de façon classique, la plaquette PQS comporte sur sa surface des chemins de découpe CHD qui délimitent des pastilles de silicium PST supportant en général un circuit intégré CI. Une fois les circuits intégrés réalisés, la plaquette PQS est découpée à la scie selon les chemins de découpe, de façon à obtenir les différentes pastilles supportant les circuits intégrés.

On peut alors associer à chaque circuit intégré CI une structure capacitive SCA que l'on va réaliser dans un chemin de découpe CHD adjacent à ce circuit intégré CI, et simultanément à la réalisation des condensateurs du circuit intégré CI et en utilisant le même process de fabrication.

Le microprocesseur de commande et de mesure ainsi que l'ampèremètre sont connectés aux plots de la structure SCA et sont disposés à l'extérieur de la plaquette.

En déterminant ensuite le coefficient de qualité de la structure capacitive SCA associée à ce circuit intégré, de la façon qui vient d'être décrite, on peut en déduire le coefficient de qualité des condensateurs du circuit intégré ainsi qu'éventuellement la résolution maximale réelle de convertisseur analogique numérique faisant partie de ce circuit intégré. Ceci permet de comparer la qualité des lots de fabrication les uns par rapport aux autres.

Bien entendu, lors de la découpe de la plaquette, les structures SCA seront détruites.

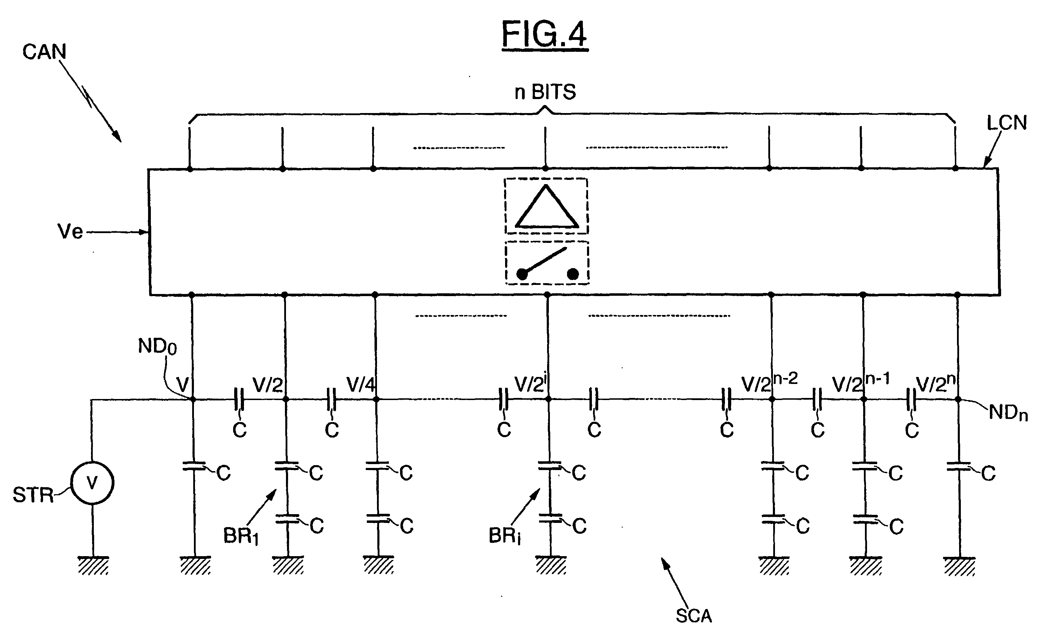

L'invention permet également avantageusement d'utiliser une structure capacitive SCA selon l'invention comme générateur de tensions de référence (ou de charges de référence "Qi") pour un convertisseur analogique-numérique CAN à capacités commutées, tel que celui illustré très schématiquement sur la figure 4. A cet égard, le noeud d'entrée de la structure SCA est relié à la tension de référence V délivrée par la source de tension de référence STR. Les différents noeuds de la structure SCA fournissent différentes tensions de référence qui sont délivrées à une logique de codage LCN, de structure classique et connue en soi. Cette logique de commande reçoit par ailleurs la tension analogique Ve à convertir.

Par un système classique de commutateurs associé à un amplificateur rebouclé par une capacité, et une logique dichotomique associée à un comparateur, la sortie du convertisseur analogique-numérique fournit un mot numérique sur n bits correspondant à la tension analogique d'entrée Ve.

Une telle structure SCA est particulièrement intéressante pour l'utilisation au sein d'un convertisseur analogique-numérique en raison de son caractère très peu sensible (robuste) aux défauts d'appariement. En effet, si un défaut d'appariement ou de non-linéarité existe entre des condensateurs de la structure SCA à un noeud donné, ce défaut d'appariement de nature aléatoire sera successivement divisé par deux et compensé en moyenne au fur et à mesure de la progression dans les noeuds suivants.

Même si le mode de réalisation illustré ci-avant pour la structure SCA (deux condensateurs par branche; r=1) est particulièrement avantageux pour une application binaire, il serait possible d'utiliser des valeurs de r plus élevées, par exemple r=2. Ceci conduirait à avoir trois condensateurs par branche et deux condensateurs en série reliant deux noeuds adjacents. On obtiendrait alors des tensions successivement divisées par trois et une valeur capacitive constante en chaque noeud égale à 4C/3.

**Revendications**

1. Dispositif de contrôle de condensateurs intégrés théoriquement identiques, comprenant

    une structure capacitive (SCA) possédant un noeud d'entrée ($ND_0$) et n noeuds de sortie ($ND_i$), n étant un entier supérieur ou égal à 2, r condensateurs intégrés (C) connectés en série entre deux noeuds voisins, r étant un entier supérieur ou égal à 1, un condensateur intégré (C) connecté entre le noeud d'entrée ($ND_0$) et la masse, un condensateur intégré connecté (C) entre le $n^{ème}$ noeud de sortie ($ND_n$) et la masse, r branches capacitives ($BR_i$) connectées en parallèle entre la masse et chaque noeud de la structure capacitive incluant le premier noeud de sortie ($ND_1$) et le n-$1^{ème}$ noeud de sortie ($ND_{n-1}$), chaque branche ($BR_i$) comportant r+1 condensateurs intégrés (C) connectés en série, tous les condensateurs (C) de la structure capacitive étant théoriquement identiques, '
    des moyens de charge (MCH) aptes à charger chaque noeud de la structure capacitive,
    des moyens de mesure ($S_i$, Amp) aptes à mesurer la charge en chacun des noeuds de la structure, et
    des moyens de comparaison aptes à comparer chaque valeur nodale de charge mesurée avec une valeur nodale de charge théorique compte tenu d'une tolérance nodale prédéterminée.

2. Dispositif selon la revendication 1, **caractérisé par le fait que** r est égal à 1.

3. Dispositif selon la revendication 1 ou 2, **caractérisé par le fait que** les moyens de charge (MCH) comportent une source de tension de référence (STR), et un interrupteur commandable ($S_v$) connecté entre la source de tension et le noeud d'entrée.

4. Dispositif selon l'une des revendications précédentes, **caractérisé par le fait que** les moyens de mesure comportent pour chaque noeud de la structure capacitive, un interrupteur commandable de mesure ($S_i$) connecté audit noeud, et un ampèremètre (Amp) apte à être connecté entre l'interrupteur de mesure et la masse.

5. Dispositif selon l'une des revendications précédentes, **caractérisé par le fait qu'**il comprend, pour chaque noeud de la structure capacitive, un interrupteur commandable de décharge ($S_{res}$) connecté entre ledit noeud et la masse.

6. Dispositif selon l'une des revendications précédentes, utilisé pour le contrôle de condensateurs intégrés appartenant à un circuit intégré (CI) situé sur une pastille (PSI) d'une plaquette semi-conductrice (PQS) et délimitée par des chemins de découpe (CHD) ménagés dans ladite plaquette, **caractérisé par le fait que** la structure capacitive (SCA) est insérée dans l'un des chemins de découpe délimitant ladite pastille, la surface d'armature des condensateurs (C) de la structure capacitive étant au plus égale à la surface minimale d'armature des condensateurs du circuit intégré.

7. Convertisseur analogique-numérique, comportant un générateur de tensions ou de charges de référence aptes à être comparées à une tension ou charge analogique à convertir, **caractérisé par le fait que** le générateur de tensions ou de charges de référence comporte une structure capacitive (SCA) selon la revendication 1 ou 2, et une source de tension (STR) connectée au noeud d'entrée ($ND_0$), le noeud de sortie ($ND_n$) étant connecté à la masse, les différentes tensions ou charges de référence étant respectivement disponibles au niveau des différents noeuds ($ND_i$) de la structure capacitive.

8. Procédé de contrôle de condensateurs intégrés théoriquement identiques, dans lequel

on réalise une structure capacitive (SCA) possédant un noeud d'entrée et n noeuds de sortie, n étant un entier supérieur ou égal à 2, r condensateurs intégrés connectés en série entre deux noeuds voisins, r étant un entier supérieur ou égal à 1, un condensateur intégré connecté entre le noeud d'entrée et la masse, un condensateur intégré connecté entre le $n^{ème}$ noeud de sortie et la masse, r branches capacitives connectées en parallèle entre la masse et chaque noeud de la structure capacitive incluant le premier noeud de sortie et le $n-1^{ème}$ noeud de sortie, chaque branche comportant r+1 condensateurs intégrés connectés en série, tous les condensateurs de la structure capacitive étant théoriquement identiques,
on charge chaque noeud ($ND_i$) de la structure capacitive,
on mesure la charge en chacun des noeuds ($ND_i$) de la structure, et
on compare chaque valeur nodale de charge mesurée avec une valeur nodale de charge théorique compte tenu d'une tolérance nodale prédéterminée.

9. Procédé selon la revendication 8, **caractérisé par le fait que** la charge d'un noeud ($ND_i$) et la mesure de la charge en ce noeud ($ND_i$) comporte la succession des étapes suivantes, effectuées à une fréquence prédéterminée pendant une durée prédéterminée:

- décharge de tous les noeuds,
- charge de tous les noeuds,
- connexion d'un ampèremètre (Amp) entre le noeud à mesurer ($ND_i$) et la masse,
- déconnexion de l'ampèremètre (Amp).

10. Utilisation du procédé selon l'une des revendications 8 ou 9, pour le contrôle de condensateurs ou de la résolution maximale de convertisseurs analogiques-numériques à capacités commutées réalisés sur une plaquette semi-conductrice.

**Patentansprüche**

1. Vorrichtung zum Überprüfen von theoretisch identischen integrierten Kondensatoren, mit:

einer kapazitiven Struktur (SCA), die aufweist: einen Eingangsknoten ($ND_0$) und n Ausgangsknoten ($ND_i$), wobei n eine ganze Zahl größer oder gleich 2 ist, r integrierte Kondensatoren (C), die in Reihe zwischen zwei benachbarten Knoten angeordnet sind, wobei r eine ganze Zahl größer oder gleich 1 ist, einen integrierten Kondensator (C), der zwischen dem Eingangsknoten ($ND_0$) und der Masse angeordnet ist, einen integrierten Kondensator (C), der zwischen dem n-ten Ausgangsknoten ($ND_n$) und der Masse angeordnet ist, r kapazitive Zweige ($BR_i$), die parallel zwischen der Masse und jedem Knoten der kapazitiven Struktur einschließlich des ersten Ausgangsknoten ($ND_1$) und des (n-1)-ten Ausgangsknoten ($ND_{n-1}$) angeordnet sind, wobei jeder Zweig ($BR_i$) r+1 in Reihe angeordnete integrierte Kondensatoren (C) aufweist, wobei alle Kondensatoren (C) der kapazitiven Struktur theoretisch identisch sind,

Aufladungseinrichtungen (MCH), die geeignet sind, jeden Knoten der kapazitiven Struktur aufzuladen,

Meßeinrichtungen ($S_i$, Amp), die geeignet sind, die Aufladung an jedem Knoten der Struktur zu messen, und

Vergleichseinrichtungen, die geeignet sind, jeden gemessenen Knotenaufladungswert mit einem theoretischen Knotenaufladungswert unter Berücksichtigung einer vorgegebenen Knotentoleranz zu vergleichen.

2. Vorrichtung nach Anspruch 1, **dadurch gekennzeichnet, daß** r gleich 1 ist.

3. Vorrichtung nach Anspruch 1 oder 2, **dadurch gekennzeichnet, daß** die Aufladungseinrichtungen (MCH) eine Referenzspannungsquelle (STR) und einen steuerbaren Unterbrecher ($S_v$) aufweisen, der zwischen der Spannungsquelle und dem Eingangsknoten angeordnet ist.

4. Vorrichtung nach einem der vorstehenden Ansprüche, **dadurch gekennzeichnet, daß** die Meßeinrichtungen für jeden Knoten der kapazitiven Struktur einen mit diesem Knoten verbundenen steuerbaren Meßunterbrecher ($S_i$) und ein Amperemeter (Amp) aufweisen, das geeignet ist, zwischen dem Meßunterbrecher und der Masse angeschlossen zu werden.

5. Vorrichtung nach einem der vorstehenden Ansprüche, **dadurch gekennzeichnet, daß** sie für jeden Knoten der kapazitiven Struktur einen steuerbaren Entladungsunterbrecher ($S_{res}$) aufweist, der zwischen diesem Knoten und der Masse angeordnet ist.

6. Vorrichtung nach einem der vorstehenden Ansprüche zur Verwendung für die Überprüfung von integrierten Kondensatoren, die zu einer integrierten Schaltung (CI) gehören, die auf einem Chip (PSI) einer Halbleiterscheibe (PQS) angeordnet ist, der durch in die Scheibe gearbeitete Schnittlinien begrenzt ist, **dadurch gekennzeichnet, daß** die kapazitive Struktur (SCA) in die Schnittlinien, die den Chip begrenzen, eingefügt ist, wobei die Belagoberfläche der Kondensatoren (C) der kapazitiven Struktur höchstens gleich der minimalen Belagoberfläche der Kondensatoren der integrierten Schaltung ist.

7. Analog/Digital-Wandler mit einem Generator von Referenzspannungen oder -ladungen, die geeignet sind, mit einer zu wandelnden analogen Spannung oder Ladung verglichen zu werden, **dadurch gekennzeichnet, daß** der Generator von Referenzspannungen oder -ladungen eine kapazitive Struktur (SCA) nach Anspruch 1 oder 2 und eine mit dem Eingangsknoten ($ND_0$) verbundene Spannungsquelle (STR) aufweist, wobei der Ausgangsknoten ($ND_n$) mit der Masse verbunden ist, wobei die unterschiedlichen Referenzspannungen oder -ladungen jeweils bezüglich der unterschiedlichen Knoten ($ND_i$) der kapazitiven Struktur verfügbar sind.

8. Verfahren zum Überprüfen von theoretisch identischen integrierten Kondensatoren, in welchem

man eine kapazitive Struktur (SCA) herstellt, die aufweist: einen Eingangsknoten und n Ausgangsknoten, wobei n eine ganze Zahl größer oder gleich 2 ist, r integrierte Kondensatoren, die in Reihe zwischen zwei benachbarten Knoten angeordnet sind, wobei r eine ganze Zahl größer oder gleich 1 ist, einen integrierten Kondensator, der zwischen dem Eingangsknoten und der Masse angeordnet ist, einen integrierten Kondensator, der zwischen dem n-ten Ausgangsknoten und der Masse angeordnet ist, r kapazitive Zweige, die parallel zwischen der Masse und jedem Knoten der kapazitiven Struktur, einschließlich des ersten Ausgangsknoten ($ND_1$) und des (n-1)-ten Ausgangsknoten, angeordnet sind, wobei jeder Zweig r+1 in Reihe angeordnete integrierte Kondensatoren aufweist, wobei alle Kondensatoren der kapazitiven Struktur theoretisch identisch sind,

man jeden Knoten ($ND_i$) der kapazitiven Struktur auflädt,

man die Ladung an jedem Knoten ($ND_i$) der Struktur mißt, und

man jeden gemessenen Knotenaufladungswert mit einem theoretischen Knotenaufladungswert unter Berücksichtigung einer vorgegebenen Knotentoleranz vergleicht.

9. Verfahren nach Anspruch 8, **dadurch gekennzeichnet, daß** das Aufladen eines Knotens ($ND_i$) und das Messen der Ladung an diesem Knoten ($ND_i$) die Reihenfolge der folgenden Schritte aufweist, die mit einer vorgegebenen Frequenz während einer vorgegebenen Zeitdauer ausgeführt werden:

- Entladen aller Knoten,
- Aufladen aller Knoten,
- Anschließen eines Amperemeters (Amp) zwischen dem zu messenden Knoten (ND$_i$) und der Masse,
- Abklemmen des Amperemeters (Amp).

10. Verwendung des Verfahrens nach einem der Ansprüche 8 oder 9 zum Überprüfen von Kondensatoren oder der maximalen Auflösung von auf einer Halbleiterscheibe hergestellten, kapazitiv geschalteten Analog/Digital-Wandlern.

**Claims**

1. Device for checking theoretically identical integrated capacitors, comprising:

   - a capacitive structure (CAS) possessing an input node (ND$_0$) and n output nodes (ND$_i$), n being an integer greater than or equal to 2, r integrated capacitors (C) connected in series between two adjacent nodes, r being an integer greater than or equal to 1, an integrated capacitor (C) connected between the input node (ND$_0$) and earth, an integrated capacitor (C) connected between the nth output node (ND$_n$) and earth, r capacitive branches (BR$_i$) connected in parallel between earth and each node of the capacitive structure including the first output node (ND$_1$) and the (n-1)th output node (ND$_{n-1}$) each branch (BR$_i$) comprising r+1 series-connected integrated capacitors (C), all the capacitors (C) of the capacitive structure being theoretically identical;
   - charging means (CHM) capable of charging each node of the capacitive structure;
   - measurement means (S$_i$, Amp) capable of measuring the charge at each of the nodes of the structure; and
   - comparison means capable of comparing each measured nodal charge value with a theoretical nodal charge value taking into account a predetermined nodal tolerance.

2. Device according to Claim 1, **characterized in that** r is equal to 1.

3. Device according to Claim 1 or 2, **characterized in that** the charging means (CHM) comprise a reference voltage source (RVS) and a controllable switch (S$_v$) connected between the voltage source and the input node.

4. Device according to one of the preceding claims, **characterized in that** the measurement means comprise, for each node of the capacitive structure, a controllable measurement switch (S$_i$) connected to the said node and an ammeter (Amp) capable of being connected between the measurement switch and earth.

5. Device according to one of the preceding claims, **characterized in that** it comprises, for each node of the capacitive structure, a controllable discharge switch (S$_{res}$) connected between the said node and earth.

6. Device according to one of the preceding claims, used for checking integrated capacitors belonging to an integrated circuit (IC) located on a die (DIE) of a semiconductor wafer (SCW) and bounded by dicing streets (DS) made in the said wafer, **characterized in that** the capacitive structure (CAS) is inserted into one of the dicing streets by which the said die is bounded, the plate surface area of the capacitors (C) of the capacitive structure being at most equal to the minimum plate surface area of the capacitors of the integrated circuit.

7. Analogue-digital converter, comprising a reference voltage or charge generator which generates reference voltages or charges that can be compared with an analogue voltage or charge to be converted, **characterized in that** the reference voltage or charge generator comprises a capacitive structure (CAS) according to Claim 1 or 2 and a voltage source (RVS) connected to the input node (ND$_0$), the output node (ND$_n$) being connected to earth and the various reference voltages or charges being available at the various nodes (ND$_i$) of the capacitive structure, respectively.

8. Method for checking theoretically identical integrated capacitors, in which:

   - a capacitive structure (CAS) is produced which possesses an input node and n output nodes, n being an integer greater than or equal to 2, r integrated capacitors connected in series between two adjacent nodes, r being an integer greater than or equal to 1, an integrated capacitor connected between the input node and earth, an integrated capacitor connected between the nth output node and earth, r capacitive branches connected in parallel between earth and each node of the capacitive structure including the first output node and the (n-1)th output node, each branch comprising r+1 series-connected integrated capacitors, all the capacitors of the capacitive structure being theoretically identical;

- each node ($ND_i$) of the capacitive structure is charged;
- the charge at each of the nodes ($ND_i$) of the structure is measured; and
- each measured nodal charge value is compared with a theoretical nodal charge value taking into account a predetermined nodal tolerance.

9. Method according to Claim 8, **characterized in that** the charge at a node ($ND_i$) and the measurement of the charge at this node ($ND_i$) comprise the succession of the following steps, carried out at a predetermined frequency over a predetermined time:

- discharging of all the nodes;
- charging of all the nodes;
- connection of an ammeter (Amp) between the node ($ND_i$) to be measured and earth;
- disconnection of the ammeter (Amp).

10. Use of the method according to either of Claims 8 and 9 for checking capacitors or the maximum resolution of switched-capacitor analogue-digital converters produced on a semiconductor wafer.

# FIG.1

EP 1 162 748 B1

## FIG.2

# FIG.3

FIG.4

EP 1 162 748 B1